# EUROPEAN PATENT SPECIFICATION

(11) **EP 1 061 427 B1**
(45) Date of publication and mention of the grant of the patent: **11.09.2002**
(21) Application number: 99830369.7
(22) Date of filing: 15.06.1999
(51) Int. Cl.: G05F 1/569, H03F 1/52

(54) **Controlled current, voltage mode driving stage**
Spannungsgesteuerte Treiberstufe mit geregeltem Strom
Etage d'attaque en tension avec commande de courant

(43) Date of publication of application: 20.12.2000
(73) Proprietor: STMicroelectronics S.r.l., 20041 Agrate Brianza (Milano) (IT)
(72) Inventor: Brambilla, Davide, 20017 Rho (IT); Capodivacca, Giovanni, 21053 Castellanza (IT); Ranieri, Danilo, 20099 Sesto S. Giovanni (IT)
(74) Representative: Pellegri, Alberto

(56) References cited:
- US-A- 4 258 406
- US-A- 4 599 578
- US-A- 5 084 668

## Description

### BACKGROUND OF THE INVENTION

The invention relates to integrated circuits and in particular output power stages. The invention concerns a method and relative implementing stage for driving with a controlled current a load.

More specifically the invention relates to an output stage that is able to drive in a voltage mode a load and which is current controlled, such that the driving of the load is normally performed in a voltage mode one and whenever the load requires a particularly high current, the driving is performed in a current mode.

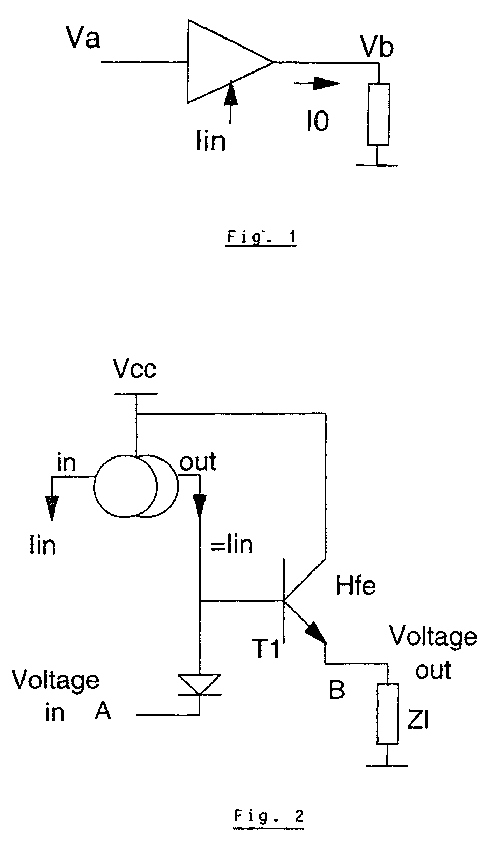

In Fig. 1 such a stage is schematized, in which the load driving is normally in voltage mode (Vb=Va) and when the current absorbed by the load become excessive the driving is automatically controlled in current mode (I0=K*In).

Sometimes it becomes necessary that such an output stage be requested to deliberately drive a load with a controlled current, i.e. with a current of a smaller value than the current that could be absorbed by the external load in absence of a specific control of the delivered current.

Furthermore, a full output voltage swing, and the ability to meet constraints of the output voltage in terms of limits to below ground (body potential) and above supply voltages, which may be provoked by particular operating conditions or by noise induced by the load, are often requested.

Because of the need of having an extended wide range of operating voltages (e.g. in the car radio segment), it is necessary to realize driving stages with a low voltage drop.

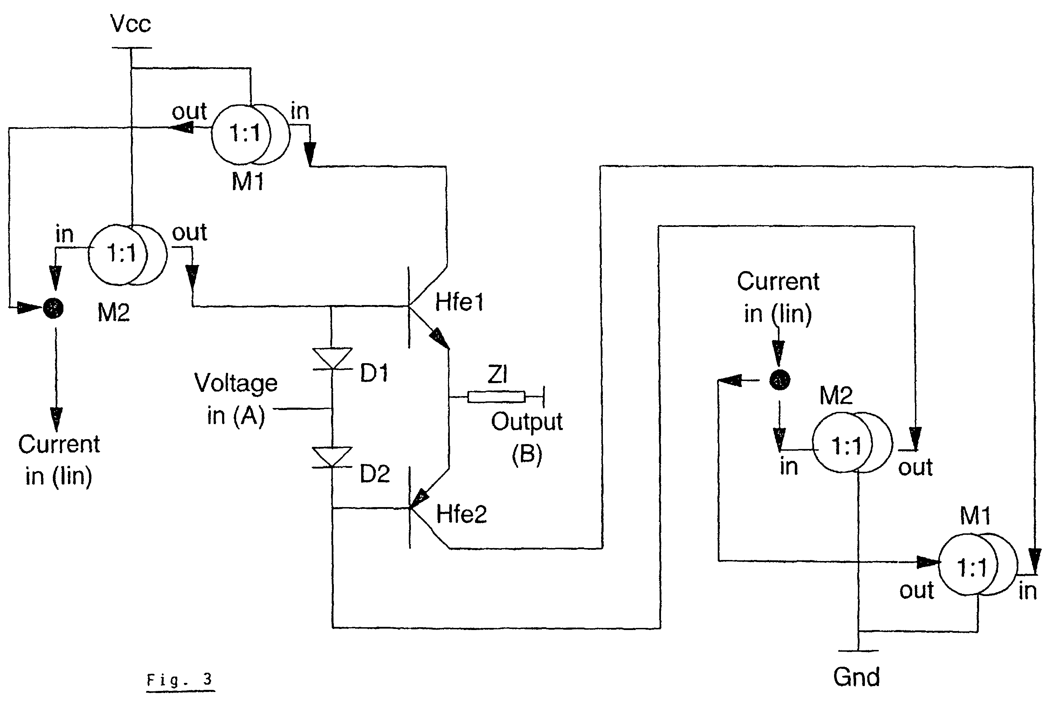

Normally, solutions such as the one depicted in Fig.2 are used.

According to the known approach, a voltage mode driving, from node A to node B, is realized, which becomes automatically a current mode driving whenever the load requires a current greater than Hfe*Iin (where Hfe is the current gain of the transistor T1). The input variables of the circuit are the voltage produced on the A node by the circuit that precedes the output stage (not illustrated in figure) and the current Iin, injected by the circuit preceding the output stage.

The known solution is disadvantageous because the output current depends to a significant extent the parameters of the manufacturing process and temperature, besides the level of the signal itself, but not linearly because of the variability of the Hfe parameter of the transistor of the output stage depending from the collector current.

The circuit of the known solution may develop output voltages below ground and above the supply voltage. It is able to drive only loads referred (connected) to ground, and to be able to deliver and to absorb current it must be associated to a correspondent dual structure.

US-A-4,599,578 discloses a method for applying a driving voltage to a load using a bipolar junction drive transistor by measuring the load current on the emitter side of the transistor, generating a measured output current proportional to the load current generating a current different by comparing the measured output current with a reference current and injecting a current proportional to the current difference into the base of the bipolar drive transistor.

US-A-4,258,406 discloses a circuit for protecting output transistors of a push-pull output amplifier based on detecting the collector current or the emitter current of the transistor to be protected on a current sensing resistor and applying the detected signal to a control transistor via an emitter-collector path of a transistor having a register connected across the collector and the base.

### OBJECT AND SUMMARY OF THE INVENTION

An object of the invention is to provide an improved driving method and an output stage that couples low voltage drop and wide range of operating voltage characteristics (from below ground values to above supply values) with those of an improved current control with relatively small input currents, being less dependent from process spread and from temperature, irrespectively of the level of the input voltage signal.

Basically the method of voltage driving with controlled current of the invention consists in realizing a negative feedback of the output current, measured on the collector of the transistor of the output stage, in comparing the current measured at the transistor collector with the input current and injecting the current difference in the base of the transistor on which node the voltage driving insists. The above underlying problems are solved according to the independent claims 1 and 2.

### BRIEF DESCRIPTION OF THE DRAWINGS

**Figure 1** is a basic scheme of an output stage for voltage driving with a current controlled, a load according to a known technique, as discussed above.

**Figure 2** shows the basic circuit of a known output stage, according to the scheme of Fig. 1.

**Figure 3** shows the basic circuit of a fully complementary output stage, made according to the present invention.

**Figure 3a** shows a basic circuit of a unipolar stage of the invention, capable only of delivering current to a load.

**Figure 3b** shows a dual version of the circuit of Fig. 3a, capable of driving a load referred to the positive supply rail instead of to ground.

**Figure 4** shows an alternative embodiment of an output stage according to the present invention.

**Figure 5** shows another alternative embodiment of an output stage according to the present invention.

### DESCRIPTION OF SEVERAL EMBODIMENTS OF THE INVENTION

The circuit of Fig. 2 represents an embodiment of a fully complementary stage as often preferred in order to maximize the efficiency and the output voltage swing.

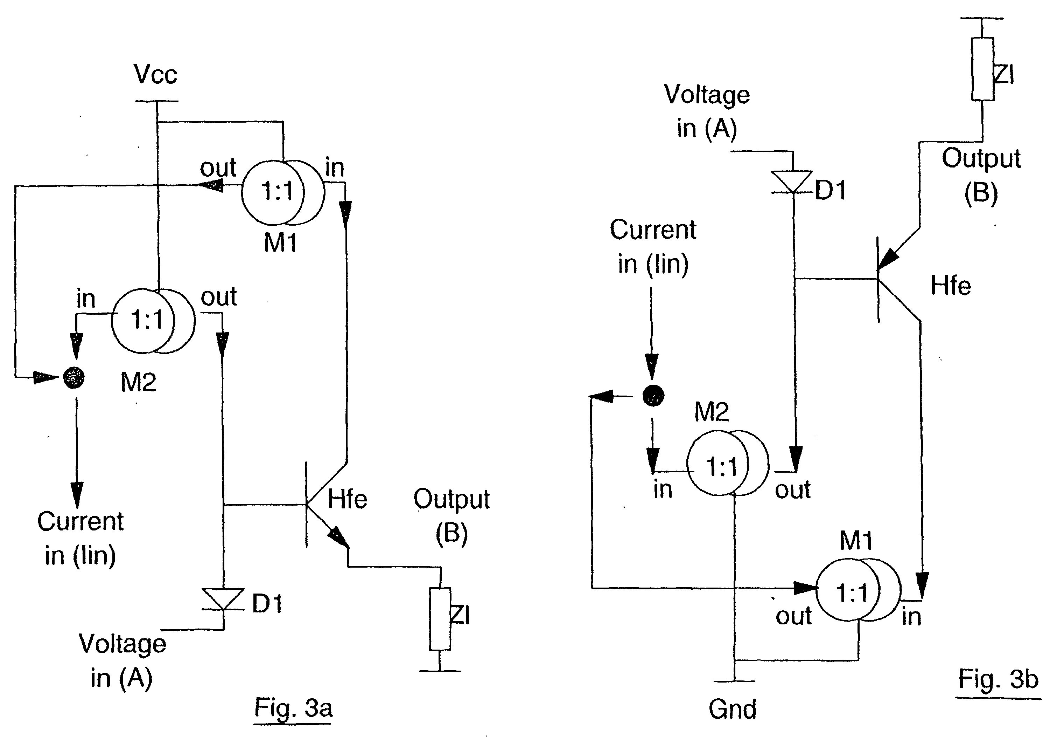

Being complementary embodiment substantially a duplication of unipolar basic circuits, the functioning of the circuit of the invention will be more easily illustrated by referring to a basic circuit of unipolar kind, as the one illustrated in Fig. 3a.

Under normal load condition, i.e. when the current delivered to the load Z1 is sufficient to fully cover the current absorbed by the load, within the imposed limit of maximum output current deliverable by the stage, the diode D 1 results turned on, thus enabling the voltage driving of the base of the output transistor T1. Therefore, the load is driven in voltage mode.

In these operating conditions, the excess current on the base node of the transistor is absorbed by the circuit that precedes the voltage input node A of the output stage.

When the output current becomes insufficient to satisfy the current requisite of the load (because of a load increase), that is when the output current exceeds the maximum allowed limit, the diode D1 is reverse biased and the stage remains under closed loop control through the negative feedback of the current read on the collector of the output transistor T1, thus ensuring a control of the current delivered to the load according to I0=K*Iin, where in the illustrated example K=1, being the current gain of the stage equal to one.

The scheme of Fig. 3b is functionally similar to the scheme of Fig. 3a. It represents the dual version of the circuit of Fig. 3a, for driving a load referred to the positive supply voltage node instead of to ground.

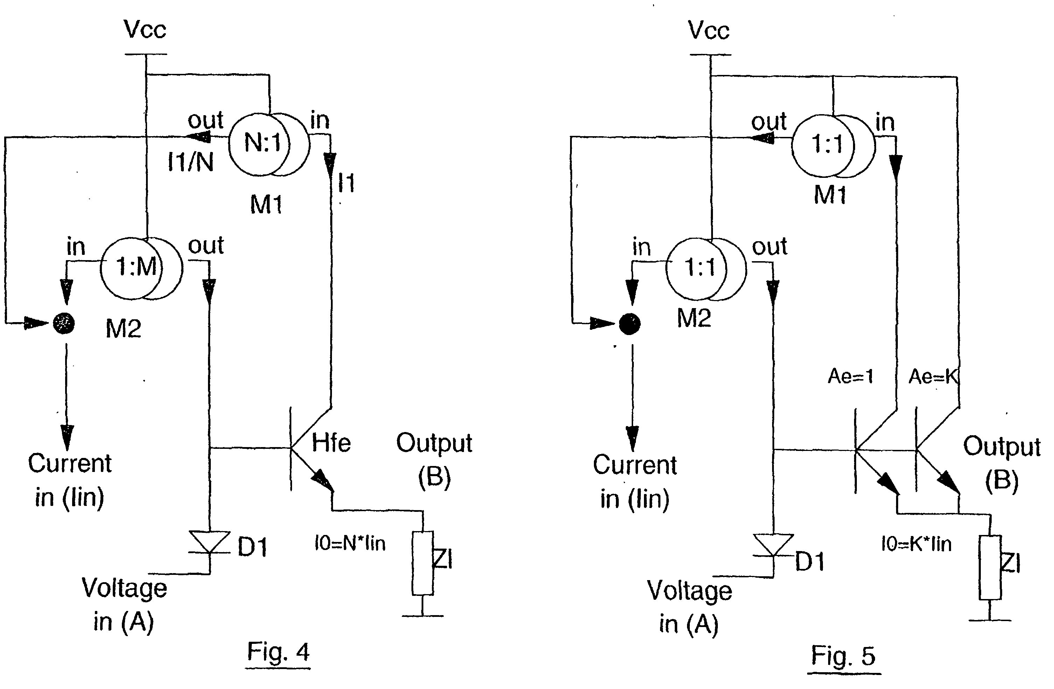

The alternative embodiment of the circuit of the invention illustrated in Fig. 4, is useful in applications requiring a current gain greater than 1, i.e. when K=N (N>1). It is adequate to use a proper current mirroring ratio in monitoring the collector current of the output NPN transistor (feedback current mirror M1). The current gain corresponds to the reciprocal of the current mirroring ratio of the feedback mirror M1.

In these cases, it may be necessary to provide for a certain gain of the current mirror M2 of the direct path of the current signal in order to obtain the desired loop gain.

yet another alternative embodiment of the circuit of the invention is shown in Fig. 5. The purpose of this alternative scheme is to save integration area by realizing the feedback loop with a current mirror M1 that does not have to monitor necessarily the whole collector current of the output transistor of the stage, but just a fractional current of the collector, read on a suitably scaled structure of the output transistor. Given that the feedback current mirror is typically realized with PNP transistors, this expedient allows a considerable saving of integration area.

Thus, it is possible to use a low current reference (because the gain current is lower than 1) and a smaller silicon area will be required to realize the current mirror of the feedback loop.

Naturally, even the alternative embodiments of the basic circuit of the invention of Figures 4 and 5, may be realized in a fully complementary version, similar to that illustrated in Fig.2.

## Claims

1. A method of voltage driving with a controlled current a load (Z1) referred to ground or to a supply voltage (Vcc) using a stage including at least a transistor (T1), with an emitter coupled to the load (Z1) and a collector coupled to the supply node opposite the one to which the load (Z1) is referred and at least a first current mirror (M2) whose input (IN) is coupled to a source of an input current (Iin) and whose output (OUT) is coupled to the base of the transistor (T1) and through a directly biased diode (D1) to a node (A) coupled to a source of an input voltage (Vin), **characterized by** the steps of
mirroring the collector current of said transistor (T1) by a second current mirror (M1) referred to said supply node opposite to the node to which the load is referred and comparing said input current (Iin) with the collector current mirrored by said second mirror (M1) on a circuit node;
injecting or absorbing from said circuit node a current difference of said comparison through said first current mirror (M2) on or from the base node of said transistor (T1) or forcing or absorbing said current difference through said diode (D1) to or from a circuit preceding the stage for producing on said node (A) said input voltage (Vin).

2. A stage for voltage driving with a controlled current a load (Z1) referred to ground or to a supply voltage (Vcc), comprising at least a transistor (T1), having an emitter coupled to the load (Z1) and a collector coupled to the supply node opposite the one to which the load (Z1) is referred, at least a first current mirror (M2) whose input (IN) is coupled to a source of an input current (Iin) and whose output (OUT) is coupled to the base of the transistor (T1) and by a directly biased diode (D1) to a node (A) coupled to a source of an input voltage (Vin), **characterized in that**
the collector of said transistor (T1) is coupled to the input of a second current mirror (M1), referred to said supply node opposite to the node to which the load is referred, the output of said second current mirror (M1) is coupled to a node on which said input current (Iin) and the collector current mirrored by said second current mirror (M1) are compared, the first current mirror (M2) injecting or absorbing a current difference of said comparison on or from the base node of said transistor (T1) or forcing or absorbing said current difference through said diode (D1) to or from a circuit preceding said stage and producing upon said node (A) said input voltage (Vin).

3. The stage according to claim 2, **characterized in that** said second current mirror (M1) has a mirroring ratio smaller than 1.

4. The stage according to claim 2, **characterized in that** said first current mirror (M2) has a mirroring ratio greater than 1.

5. The stage according to claim 2, **characterized in that** said second current mirror (M1) mirrors a fraction of the collector current of said transistor (T1) of the stage.

6. The stage according to any claim from 2 to 5, **characterized in that** is realized in a complementary form.

## Patentansprüche

1. Verfahren zur Spannungssteuerung mit einem gesteuerten Strom eines auf dem Erde bzw. auf einer Versorgungsspannung (Vcc) bezogenen Lasts (Z1) unter Verwendung einer mindestens einen Transistor (T1) umfassenden Stufe, mit einem mit dem Last (Z1) gekoppelten Emitter und einem Kollektor, der mit dem Versorgungsknoten gekoppelt ist, der demjenigen gegenuerberliegt auf welchem das Last (Z1) bezogen ist, und mindestens einem ersten Stromspiegel (M2) dessen Eingang (IN) mit einer Quelle eines Eingangsstromes (Iin) gekoppelt ist und dessen Ausgang (OUT) mit der Basis des Transistors (T1) und, durch eine direkt polarisierte Diode (D1), mit einem Knoten (A) gekoppelt ist, welcher Knoten (A) mit einer Quelle einer Eingangsspannung (Vin) gekoppelt ist, **gekennzeichnet durch**
Spiegelung des Kollektorstromes des genannten Transistors (T1) **durch** einen zweiten Stromspiegel (M1) bezogen auf dem genannten Versorgungsknoten, der demjenigen Knoten gegenüberliegt auf welchem die Last bezogen ist, und Vergleich des genannten Eingangsstromes (Iin) mit dem Kollektorstrom, der **durch** den genannten zweite Stromspiegel (M1) gespiegelt ist auf einem Schaltungsknoten;
Injektion oder Absorption in bzw. von dem genannten Schaltungsknoten eines Stromunterschiedes aus dem genannten Vergleich **durch** den genannten ersten Stromspiegel (M2) auf bzw. von dem Basisknoten des genannten Transistors (T1), oder Eintreiben bzw. Absorption des genannten Stromunterschiedes **durch** die genannte Diode (D1) in eine bzw. von einer der Stufe vorgeschaltete(n) Schaltung zur Erzeugung der genannten Eingangsspannung (Vin) auf dem genannten Knoten (A).

2. Stufe zur Spannungssteuerung mit einem gesteuerten Strom eines auf dem Erde bzw. auf einer Versorgungsspannung (Vcc) bezogenen Lasts (Z1), mindestens umfassend einen Transistor (T1), der einen mit dem Last (Z1) gekoppelten Emitter und einen Kollektor, der mit dem Versorgungsknoten gekoppelt ist, der demjenigen gegenüberliegt auf welchem das Last (Z1) bezogen ist, mindestens einen ersten Stromspiegel (M2) dessen Eingang (IN) mit einer Quelle eines Eingangsstromes (Iin) gekoppelt ist und dessen Ausgang (OUT) mit der Basis des Transistors (T1) und, durch eine direkt polarisierte Diode (D1), mit einem Knoten (A) gekoppelt ist, welcher Knoten (A) mit einer Quelle einer Eingangsspannung (Vin) gekoppelt ist aufweist, **dadurch gekennzeichnet, dass**
der Kollektor des genannten Transistors (T1) mit dem Eingang eines zweiten Stromspiegels (M1) bezogen auf dem genannten Versorgungsknoten, der demjenigen Knoten gegenüberliegt auf welchem das Last bezogen ist, gekoppelt ist, der Ausgang des genannten zweiten Stromspiegels (M1) mit einem Knoten gekoppelt ist auf welchem der genannte Eingangsstrom (Iin) und der durch den genannten zweiten Stromspiegel (M1) gespiegelte Kollektorstrom verglichen werden, wobei der erste Stromspiegel (M2) einen Stromunterschiedes aus dem genannten Vergleich durch das genannte erste Stromspiegel (M2) auf bzw. von dem Basisknoten des genannten Transistors (T1), injiziert oder absorbiert, bzw. den genannten Stromunterschied durch die genannte Diode (D1) in eine bzw. von einer der genannten Stufe vorgeschaltete(n) Schaltung eintreibt oder absorbiert und auf den genannten Knoten (A) die genannte Eingangsspannung (Vin) erzeugt.

3. Stufe nach Anspruch 2, **dadurch gekennzeichnet, dass** der genannte zweite Stromspiegel (M1) ein Spiegelungsverhältnis von kleiner als 1 aufweist.

4. Stufe nach Anspruch 2, **dadurch gekennzeichnet, dass** der genannte erste Stromspiegel (M2) ein Spiegelungsverhältnis von größer als 1 aufweist.

5. Stufe nach Anspruch 2, **dadurch gekennzeichnet, dass** der genannte zweite Stromspiegel (M1) einen Anteil des Kollektorstromes des genannten Transistors (T1) der Stufe spiegelt.

6. Stufe nach irgendeinem Anspruch 2 bis 5, **dadurch gekennzeichnet, dass** sie in einer komplementären Form ausgeführt ist.

## Revendications

1. Méthode de pilotage tension, avec un courant contrôlé, d'une charge (Z1) par rapport à la terre ou à une tension d'alimentation (Vcc) en utilisant un étage comprenant au moins un transistor (T1), avec un émetteur couplé à la charge (Z1) et un collecteur couplé au noeud d'alimentation opposé à celui auquel la charge (Z1) est référencée et au moins un premier miroir de courant (M2) l'entrée (IN) duquel est couplée à une source d'un courant entrant (Iin) et la sortie (OUT) duquel est couplée à la base du transistor (T1) et, par une diode (D1) polarisée directement, à un noeud (A) couplé à une source d'une tension entrante (Vin), **caractérisée par** les étapes de
réfléchissement du courant de collecteur dudit transistor (T1) par un deuxième miroir de courant (M1) référencée audit noeud d'alimentation opposé à celui auquel la charge est référencée et comparaison dudit courant entrant (Iin) avec le courant de collecteur réfléchi par ledit deuxième miroir (M1) sur un noeud du circuit;
injection ou absorption dudit noeud de circuit d'une différence de courant de ladite comparaison par ledit premier miroir de courant (M2) sur ou depuis le noeud de base dudit transistor (T1), ou forcement ou absorption de ladite différence de courant par ladite diode (D1) vers ou depuis un circuit qui précède l'étage pour produire sur ledit noeud (A) ladite tension entrante (Vin).

2. Etage de pilotage tension, avec un courant contrôlé, d'une charge (Z1) par rapport à la terre ou à une tension d'alimentation (Vcc), comprenant au moins un transistor (T1) ayant un émetteur couplé à la charge (Z1) et un collecteur couplé au noeud d'alimentation opposé à celui auquel la charge (Z1) est référencée, au moins un premier miroir de courant (M2) l'entrée (IN) duquel est couplée à une source d'un courant entrant (Iin) et la sortie (OUT) duquel est couplée à la base du transistor (T1) et, par un diode (D1) polarisée directement, à un noeud (A) couplé à une source d'une tension entrante (Vin), **caractérisé en ce que**
le collecteur dudit transistor (T1) est couplé à l'entrée d'un deuxième miroir de courant (M1), référencée audit noeud d'alimentation opposé à celui auquel la charge est référencée, la sortie dudit deuxième miroir de courant (M1) est couplée à un noeud sur lequel ledit courant entrant (Iin) et le courant de collecteur réfléchi par ledit deuxième miroir de courant (M1) sont comparés, le premier miroir de courant (M2) injectant ou absorbant une différence de courant de ladite comparaison vers ou depuis le noeud de base dudit transistor (T1), ou forçant ou absorbant ladite différence de courant par ladite diode (D1) vers ou depuis un circuit qui précède ledit étage et produisant sur ledit noeud (A) ladite tension entrante (Vin).

3. Etage selon la revendication 2, **caractérisé en ce que** ledit deuxième miroir de courant (M1) a un rapport de réfléchissement mineur d'1.

4. Etage selon la revendication 2, **caractérisé en ce que** ledit premier miroir de courant (M2) a un rapport de réfléchissement majeur d'1.

5. Etage selon la revendication 2, **caractérisé en ce que** ledit deuxième miroir de courant (M1) réfléchit une fraction du courant de collecteur dudit transistor (T1) de l'étage

6. Etage selon l'une quelconque des revendications 2 à 5, **caractérisé en ce qu'**il est réalisé dans une forme complémentaire.
